# EUROPEAN PATENT APPLICATION

(11) **EP 4 668 293 A1**
(43) Date of publication of application: **24.12.2025**
(21) Application number: 25182318.3
(22) Date of filing: 12.06.2025
(51) Int. Cl.: H01F 1/147, B22F 1/16, B22F 9/08

(54) **IRON-BASED MAGNETIC POWDERY/GRANULAR MATERIAL, METHOD FOR MANUFACTURING SAME, AND MAGNETIC MATERIAL**

(30) Priority: 17.06.2024 JP 2024097409
(71) Applicant: SINTOKOGIO, LTD., Nakamura-ku Nagoya-shi Aichi 4506424 (JP)
(72) Inventor: KINO, Yasushi, Nagoya-Shi (JP); MIZUNO, Takehiko, Nagoya-shi (JP); HAYASHI, Shingo, Nagoya-shi (JP); YOKOI, Sota, Nagoya-shi (JP)
(74) Representative: Steffens, Adrian

(57) **Abstract**

The present disclosure provides an iron-based magnetic powdery/granular material that makes it possible to, while enhancing at least one of feasibility of reduction in size of a magnetic material, feasibility of application of the magnetic material to a high-frequency current, and magnetic properties of the magnetic material, maintain or enhance the other properties, compared to the conventional iron-based magnetic powdery/granular material containing the same amount of Ni and the same amount of Si. An iron-based magnetic powdery/granular material in accordance with the present disclosure contains an iron-based magnetic alloy composed of elements Fe, L, and M, the element L being at least one element selected from the group consisting of Ni and Si, the element M being at least one element selected from the group consisting of metal elements each having an ionization tendency higher than that of the element Fe, the elements Fe, L, and M being contained in a total amount of not less than 97.0% by weight and not more than 100.0% by weight, the element L being contained in an amount of not less than 0.0% by weight and not more than 80.0% by weight, and the element M being contained in an amount of not less than 0.3% by weight and not more than 10.0% by weight, and the iron-based magnetic powdery/granular material having a resistivity of not less than 80 µΩ·cm. (Fig.1)

## Description

### Technical Field

The present invention relates to an iron-based magnetic powdery/granular material, a method for manufacturing the same, and a magnetic material.

### Background

It has been known that compacted powder materials obtained by compression molding of iron-based magnetic powdery/granular materials that are soft magnetic exhibit excellent magnetic properties, and thus the iron-based magnetic powdery/granular materials are useful as a raw material for manufacturing magnetic materials, such as electronic components, for example. As an iron-based magnetic powdery/granular material, WO 2020/179535 discloses a magnetic material powder that consists of a crushed metal thin strip containing at least a Fe component, that is formed into a flattened spherical shape, and that has a specific aspect ratio and a specific curvature radius at a corner.

### Summary

### Technical Problem

Magnetic materials are needed to have high saturation magnetizations in order to be reduced in size. Further, magnetic materials are needed to have low core losses and high electric resistances in order to improve applicability of the magnetic materials to a high-frequency current. Furthermore, the magnetic materials are needed to have high magnetic properties, for example, high magnetic permeabilities. These properties needed in the magnetic materials are also needed in iron-based magnetic powdery/granular materials, which are raw materials thereof. However, in many cases, contrivance to enhance any of these properties of an iron-based magnetic powdery/granular material containing Ni and Si typically results in deterioration of the other properties. Therefore, it has been difficult to achieve all of reduction in size of the magnetic material, improvement in applicability of the magnetic material to a high-frequency current, and excellent magnetic properties of the magnetic material.

It is an object of an aspect of the present invention to provide an iron-based magnetic powdery/granular material that makes it possible to, while enhancing at least one of feasibility of reduction in size of a magnetic material, feasibility of application of the magnetic material to a high-frequency current, and magnetic properties of the magnetic material, maintain or enhance the other properties, compared to the conventional iron-based magnetic powdery/granular material containing the same amount of Ni and the same amount of Si.

### Solution to Problem

In order to solve the foregoing problem, an iron-based magnetic powdery/granular material in accordance with an aspect of the present invention is an iron-based magnetic powdery/granular material containing an iron-based magnetic alloy composed of elements Fe, L, and M, the element L being at least one element selected from the group consisting of Ni and Si, the element M being at least one element selected from the group consisting of metal elements each having an ionization tendency higher than that of the element Fe, in the iron-based magnetic powdery/granular material, the elements Fe, L, and M being contained in a total amount of not less than 97.0% by weight and not more than 100.0% by weight, the element L being contained in an amount of not less than 0.0% by weight and not more than 80.0% by weight, and the element M being contained in an amount of not less than 0.3% by weight and not more than 10.0% by weight, relative to 100.0% by weight of the iron-based magnetic powdery/granular material, and the iron-based magnetic powdery/granular material having a resistivity of not less than 80 µΩ·cm.

### Advantageous Effects of Invention

An iron-based magnetic powdery/granular material in accordance with an aspect of the present invention makes it possible to, while enhancing at least one of feasibility of reduction in size of a magnetic material, feasibility of application of the magnetic material to a high-frequency current, and magnetic properties of the magnetic material, maintain or enhance the other properties, compared to the conventional iron-based magnetic powdery/granular material containing the same amount of Ni and the same amount of Si.

### Brief Description of Drawings

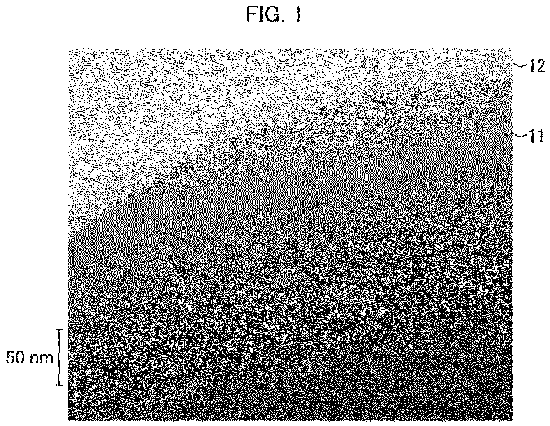

Fig. 1 is an electron micrograph of an iron-based magnetic powdery/granular material of Example 46 of the present invention.

### Description of Embodiments

### Embodiment 1

The following description will discuss an iron-based magnetic powdery/granular material in accordance with Embodiment 1 of the present invention in detail. Hereinafter, the iron-based magnetic powdery/granular material in accordance with the present embodiment may be referred to as "present powdery/granular material".

### (Composition of iron-based magnetic powdery/granular material)

The present powdery/granular material contains an iron-based magnetic alloy composed of the elements Fe, L, and M. Hereinafter, the iron-based magnetic alloy may be referred to simply as "magnetic alloy". The magnetic alloy is in particle form and typically has an amorphous structure. In the present powdery/granular material, Fe, L, and M are contained in a total amount of not less than 97.0% by weight and preferably not less than 98.0% by weight relative to 100.0% by weight of the present powdery/granular material. There is a tendency that the higher the total content is, the stronger magnetic properties derived from the magnetic alloy the present powdery/granular material exhibits. In the present powdery/granular material, Fe, L, and M are contained in a total amount of not more than 100.0% by weight relative to 100.0% by weight of the present powdery/granular material. Even if the total content is, for example, not more than 97.0% by weight, the present powdery/granular material exhibits the magnetic alloy-derived magnetic properties to a degree sufficient for practical use. Examples of elements other than the element Fe, L, or M that exist in the present powdery/granular material include impurity elements and, in a case where an oxide film is present, the element O.

L is at least one element selected from the group consisting of Ni and Si. L is preferably Ni. In a case where L is Ni, the present powdery/granular material becomes less hard than a case where L is Si, thereby leading to an improved plastic deformability and an improved filling property in a magnetic material. Therefore, the present powdery/granular material in which L is Ni is more useful as a raw material of a magnetic material. However, in the present embodiment, L is not limited to Ni, and Si or a combination of Ni and Si may be employed as L as appropriate. If Si is employed as L, the powdery/granular material has a lower coercivity than a case where Ni in a similar content is employed.

In the present powdery/granular material, L is contained in an amount of not less than 0.0% by weight relative to 100.0% by weight of the present powdery/granular material. In other words, the present embodiment encompasses a case where L is contained in an amount of 0.0% by weight, i.e., the present powdery/granular material does not contain L. Also in this case, it is possible to provide an iron-based magnetic powdery/granular material that enhances at least one of feasibility of reduction in size of a magnetic material, feasibility of application of the magnetic material to a high-frequency current, and magnetic properties of the magnetic material. L is contained in an amount of preferably not less than 2.0% by weight, more preferably not less than 3.5% by weight, and further more preferably not less than 6.5% by weight. There is a tendency that the higher the content of L is, the further the coercivity of the powdery/granular material is reduced, resulting in reduction in a core loss of a magnetic material containing the powdery/granular material. L is contained in an amount of not more than 80.0% by weight, preferably not more than 50.0% by weight, more preferably not more than 30.0% by weight, and further more preferably not more than 10.0% by weight. There is a tendency that the lower the content of L is, the further the saturation magnetization of the powdery/granular material is improved.

M is at least one element selected from the group consisting of metal elements each having a higher ionization tendency than that of Fe. For example, M is selected from the group consisting of Al, Ca, Mg, Ti, Cr, Mn, Zr, and any combination thereof. The melting point of M is preferably not higher than 1800°C for easy formation of an alloy of M and Fe. M is preferably selected from the group consisting of Al, Ca, and a combination thereof, is preferably Al or a combination of Al and Ca, and is more preferably a combination of Al and Ca.

In the present powdery/granular material, M is contained in an amount of not less than 0.3% by weight, preferably not less than 0.5% by weight, more preferably not less than 1.5% by weight, and further more preferably not less than 3.0% by weight relative to 100.0% by weight of the present powdery/granular material. Further, M is contained in an amount of not more than 10.0% by weight, preferably not more than 8.0% by weight, more preferably not more than 5.5% by weight, and further more preferably not more than 3.5% by weight. In a case where the content of M falls within these ranges, the fact that M oxidizes preferentially over Fe on the surface of the magnetic alloy allows for formation of an oxide film of M in a suitable amount on the surface while the inside magnetic alloy is maintained without oxidization. Therefore, the present powdery/granular material has both excellent magnetic properties derived from a magnetic alloy and a high resistivity derived from an oxide film.

In a case where M is a combination of Al and Ca, Al is contained in an amount of preferably not less than 1.0% by weight and more preferably not less than 3.0% by weight relative to 100.0% by weight of the present powdery/granular material. In this case, Al is contained in an amount of preferably not more than 8.0% by weight and more preferably not more than 5.0% by weight. Further, in this case, Ca is contained in an amount of preferably not less than 0.5% by weight and more preferably not less than 1.0% by weight. Furthermore, in this case, Ca is contained in an amount of preferably not more than 1.5% by weight and more preferably not more than 1.2% by weight. There is a tendency that when the contents of Al and Ca fall within these respective preferable ranges, the present powdery/granular material further enhances at least one of feasibility of reduction in size of a magnetic material, feasibility of application of the magnetic material to a high-frequency current, and magnetic properties of the magnetic material.

The content of M may be set in accordance with a particle size (D50) of the present powdery/granular material. The product of the content of M and the particle size (D50) of the present powdery/granular material is preferably not less than 1.5% by weight·µm and is more preferably not less than 3.0% by weight·µm. There is a tendency that the higher the product within this range is, the further an oxide film of M is formed in a suitable amount on the surface of the magnetic alloy, so that a resistivity of the powdery/granular material is improved. Further, the product of the content of M and the particle size (D50) of the present powdery/granular material is preferably not more than 24.0% by weight·µm and is more preferably not more than 15.0% by weight·µm. There is a tendency that the smaller the product within this range is, the further the inside magnetic alloy is maintained without oxidization, so that the magnetic properties are enhanced.

The composition of the present powdery/granular material can be measured with use of a known analysis method, such as a high-frequency inductively coupled plasma (ICP) emission spectrometry.

The present powdery/granular material preferably contains, on a surface of the magnetic alloy, an oxide film made of an oxide of the element M. The oxide film has a function of further improving a resistivity of the present powdery/granular material. The oxide film is made of an oxide of the element M having a higher ionization tendency than that of Fe, and thus can be easily formed by the oxidation of the element M by air or water without any treatment, such as a chemical treatment, sputtering, or a deposition method.

The oxide film on the surface of the present powdery/granular material can be observed with use of a known observation means, such as a scanning electron microscope or a transmission electron microscope.

### (Shape of iron-based magnetic powdery/granular material)

The particle size (D50) of the present powdery/granular material is not less than 0.3 µm and is preferably not less than 1.0 µm. There is a tendency that the larger the particle size is, the further the magnetic properties (for example, a magnetic permeability) are improved. The particle size (D50) of the present powdery/granular material is not more than 30.0 µm and is preferably not more than 10.0 µm. There is a tendency that the smaller the particle size is, the further an eddy current loss is reduced in a high-frequency range, so that a total loss is also reduced.

In the present embodiment, the particle size (D50) refers to a median diameter of the cumulative size distribution based on volume, and can be measured with use of a wet-type particle size analyzer.

### (Physical properties of iron-based magnetic powdery/granular material)

The hardness of the present powdery/granular material is preferably not more than 600 HV and is more preferably not more than 300 HV. The hardness of the present powdery/granular material tends to be lower than that of the conventional art described herein as Comparative Example. The lower the hardness is, the further the plastic deformability of the present powdery/granular material is improved, leading to a further improved filling property of the present powdery/granular material in the magnetic material. Therefore, the magnetic material containing, as a raw material, the present powdery/granular material tends to exhibit stronger magnetic properties derived from the present powdery/granular material. The lower limit of the hardness of the present powdery/granular material is not particularly limited from a viewpoint of improvement in a filling property. As one example, the hardness of the present powdery/granular material may be not less than 280 HV for providing a suitable hardness as a magnetic material to the magnetic material. The hardness of the present powdery/granular material refers to Vickers hardness in the present embodiment, and can be measured by a method described later in Examples.

The resistivity of the present powdery/granular material is not less than 80 µΩ·cm, is preferably not less than 150 µΩ·cm, and is more preferably not less than 200 µΩ·cm. The resistivity of the present powdery/granular material tends to be higher than that of the conventional art described herein as Comparative Example. In particular, the resistivity of the present powdery/granular material in which L is Si tends to be remarkably higher than that of Comparative Example that contains Si. A higher resistivity allows a larger current to be applied to the magnetic material containing the present powdery/granular material as a raw material. The upper limit of the resistivity of the present powdery/granular material is not particularly limited from a viewpoint of applicability to a large current. As one example, the resistivity of the present powdery/granular material may be not more than 210 µΩ·cm. The resistivity of the present powdery/granular material refers to volume resistivity in the present embodiment, and can be measured by a method described later in Examples.

The saturation magnetization of the present powdery/granular material is preferably not less than 120 emu/g, and is more preferably not less than 150 emu/g. A higher saturation magnetization enables the magnetic material to be further reduced in size. The upper limit of the saturation magnetization of the present powdery/granular material is not particularly limited from a viewpoint of reduction in size of the magnetic material. As one example, the saturation magnetization of the present powdery/granular material may be not more than 156 emu/g. In the present embodiment, the saturation magnetization of the present powdery/granular material can be measured with use of a magnetic measurement device.

The coercivity of the present powdery/granular material is preferably not more than 50 Oe and is more preferably not more than 40 Oe. The lower the coercivity is, the further the core loss of the magnetic material is reduced. The lower limit of the coercivity of the present powdery/granular material is not particularly limited from a viewpoint of reduction in core loss. As one example, the coercivity of the present powdery/granular material may be not less than 38 Oe. In the present embodiment, the coercivity of the present powdery/granular material can be measured with use of a magnetic measurement device.

### (Method for manufacturing iron-based magnetic powdery/granular material)

The present powdery/granular material described above can be manufactured by a manufacturing method including an atomization step and a drying step.

The atomization step is a step of obtaining a powdery/granular material made of an iron-based magnetic alloy by subjecting, to a water atomization process, a mixture composed of the elements Fe, L, and M, which are the raw materials of the present powdery/granular material. The respective contents of and the total content of the elements Fe, L, and M in the mixture are as described above for the elements Fe, L, and M in the present powdery/granular material, and thus the descriptions thereof are not repeated.

In the atomization step, a melting temperature for the mixture can be any temperature at which the iron-based magnetic alloy can be formed, and can be set as appropriate in accordance with the types of the elements L and M. One example of the melting temperature is 1500°C. In the atomization step, water whose parameters have been set so as to achieve the desired cooling conditions and a particle size is ejected at a high pressure to the molten mixture. This causes the molten mixture to scatter and solidify, thereby providing a powdery/granular material made of an iron-based magnetic alloy. The other conditions in the atomization step, e.g., a pressure, an amount, and a temperature of the water; and an orifice diameter, can be set as appropriate in accordance with the desired particle size.

The drying step is a step of drying, under reduced pressure and at a temperature of not higher than 110°C, the powdery/granular material obtained in the atomization step. The drying step allows for suitable formation of an oxide film made of an oxide of the element M on the surface of the powdery/granular material.

Further, the method for manufacturing the present powdery/granular material may further include, after the drying step, a classification step of classifying the dried powdery/granular material to obtain a powdery/granular material having a desired particle size.

### Embodiment 2

The following description will discuss a magnetic material in accordance with Embodiment 2 of the present invention in detail. The magnetic material in accordance with the present embodiment may be referred to simply as "present magnetic material".

The present magnetic material contains the iron-based magnetic powdery/granular material in accordance with Embodiment 1 (the present powdery/granular material). The present magnetic material may be, for example, a compacted powder material obtained by molding the present powdery/granular material by powder compacting. The present magnetic material may consist only of the present powdery/granular material. Alternatively, the present magnetic material may be made of the present powdery/granular material and a variety of additives, such as a resin for improving molding processability. For example, the present magnetic material may be manufactured by mixing the present powdery/granular material and a resin to prepare granulated powder and molding the granulated powder by powder compacting into a desired shape.

The filling factor of the present powdery/granular material in the present magnetic material is preferably not less than 60% by volume and is more preferably 65% by volume. The filling factor of the present powdery/granular material in the present magnetic material tends to be higher than that of the conventional art described herein as Comparative Example. The higher the filling factor is, the more excellent magnetic properties derived from the present powdery/granular material the present magnetic material exhibits. The filling factor of the present powdery/granular material in the present magnetic material is not more than 100.0% by volume.

Examples of the present magnetic material include electronic components. Examples of the electronic components include the following: commonly used electronic components, such as inductors, reactor coils, transformers, and motors; and electronic components used in a wide variety of industrial fields, such as electromagnetic valves, solenoids, and sensors in transportation equipment such as automobiles. The electronic components may be electromagnetic wave absorption shields or electromagnetic wave absorbers used in order to absorb an electromagnetic wave in a specific frequency.

Aspects of the present invention can also be expressed as follows:
As can be understood in the above descriptions, the present invention encompasses the following aspects.

Aspect 1: An iron-based magnetic powdery/granular material containing an iron-based magnetic alloy composed of elements Fe, L, and M, the element L being at least one element selected from the group consisting of Ni and Si, the element M being at least one element selected from the group consisting of metal elements each having an ionization tendency higher than that of the element Fe, in the iron-based magnetic powdery/granular material, the elements Fe, L, and M being contained in a total amount of not less than 97.0% by weight and not more than 100.0% by weight, the element L being contained in an amount of not less than 0.0% by weight and not more than 80.0% by weight, and the element M being contained in an amount of not less than 0.3% by weight and not more than 10.0% by weight, relative to 100.0% by weight of the iron-based magnetic powdery/granular material, and the iron-based magnetic powdery/granular material having a resistivity of not less than 80 µΩ·cm.

Aspect 2: An iron-based magnetic powdery/granular material in accordance with Aspect 1, in which the element L is Ni.

Aspect 3: An iron-based magnetic powdery/granular material in accordance with Aspect 1 or 2, in which the element L is Si, and the iron-based magnetic powdery/granular material has a resistivity of not less than 80 µΩ·cm.

Aspect 4: An iron-based magnetic powdery/granular material in accordance with any one of Aspects 1 to 3, in which the iron-based magnetic powdery/granular material has a particle size (D50) of not less than 0.3 µm and not more than 30.0 µm.

Aspect 5: The iron-based magnetic powdery/granular material in accordance with any one of Aspects 1 to 4, in which the iron-based magnetic powdery/granular material has a hardness of not more than 600 HV.

Aspect 6: An iron-based magnetic powdery/granular material in accordance with any one of Aspects 1 to 5, in which: the iron-based magnetic powdery/granular material has a saturation magnetization of not less than 100 emu/g; and the iron-based magnetic powdery/granular material has a coercivity of not more than 50 Oe.

Aspect 7: A magnetic material containing the iron-based magnetic powdery/granular material in accordance with any one of Aspects 1 to 6.

Aspect 8: A method for manufacturing the iron-based magnetic powdery/granular material in accordance with any one of Aspects 1 to 6, the method including: a step of subjecting a mixture composed of elements Fe, L, and M to a water atomization process to obtain a powdery/granular material made of an iron-based magnetic alloy, wherein in the mixture, the elements Fe, L, and M are contained in a total amount of not less than 97.0% by weight and not more than 100.0% by weight, the element L is contained in an amount of not less than 0.0% by weight and not more than 80.0% by weight, and the element M is contained in an amount of not less than 0.3% by weight and not more than 10.0% by weight, relative to 100.0% by weight of the mixture; and a step of drying, under reduced pressure and at a temperature of not higher than 110°C, the powdery/granular material thus obtained.

### [Additional Remark]

The present invention is not limited to the embodiments, but can be altered by a skilled person in the art within the scope of the claims. The present invention also encompasses, in its technical scope, any embodiment derived by combining technical means disclosed in differing embodiments.

### Examples

Examples of the present invention will be described below.

### [Manufacture of iron-based magnetic powdery/granular material]

Mixtures that had been prepared so as to have the compositions shown in Tables 1 to 4 were melted in a high-frequency induction furnace and were subjected to a water atomization process, so that the powdery/granular materials of Examples and Comparative Examples (Com. Examples) were obtained. The conditions of the water atomization process are as below. The compositions shown in Tables 1 to 4 represent the percentages by weight of the respective elements relative to 100% by weight of the mixture. For example, the description "Fe-6.5Si-5Al-0.5Ca" of Example 37 indicates that 6.5% by weight of Si, 5.0% by weight of Al, 0.5% by weight of Ca, and remaining 88.0% by weight of Fe are contained in 100% by weight of the mixture.

### <Water atomization condition>

- Water pressure: 100 MPa
- Water amount: 100 L/minute
- Water temperature: 20°C
- Orifice diameter: φ4 mm
- Melting temperature: 1500°C

The powdery/granular material thus obtained was dried with use of a vibration vacuum dryer (VU-60; manufactured by CHUO KAKOHKI CO., LTD.). The conditions of the drying are as follows.

### <Drying conditions>

- Temperature: 100°C
- Pressure: Not more than 10 kPa
- Time: 60 minutes

The compositions of the powdery/granular materials that had been dried were subjected to quantitative analysis using an ICP optical emission spectroscopic analyzer (SPS3500DD; manufactured by Hitachi High-Tech Science Corporation).

The powdery/granular materials that had been dried were classified with use of an airflow classifier (Turbo Classifier; manufactured by NISSHIN ENGINEERING INC.), so that desired iron-based magnetic powdery/granular materials were obtained. The particle sizes (D50) of the iron-based magnetic powdery/granular materials thus obtained were measured with use of a wet-type particle size analyzer (MT3300EX II; manufactured by MicrotracBEL Corp.).

### [Evaluation of iron-based magnetic powdery/granular material]

The iron-based magnetic powdery/granular materials manufactured as described above were evaluated as follows.

### 1. Test of hardness of powdery/granular material

The hardnesses of the powdery/granular materials under a load of 100.0 mN were measured with use of a microcompression tester (MCT-510; manufactured by Shimadzu Corporation). In the evaluation, the hardnesses of ten or more particles were measured, and an average value of the measurement values was employed.

### 2. Evaluation of resistivity

The resistivities of the powdery/granular materials were evaluated under a load of 20 kN, by a four-terminal method, and with use of a powder resistivity measuring unit (Hiresta UX and Loresta GX; manufactured by Mitsubishi Chemical Analytech Co., Ltd.).

### 3. Magnetic properties of powdery/granular material

### 3-1. Saturation magnetization

The saturation magnetizations (Ms) were evaluated on the basis of magnetization curves of the powdery/granular materials that had been measured with use of a vibrating sample magnetometer (VSM-C7-10A; TOEI INDUSTRY CO., LTD.).

### 3-2. Coercivity

The coercivities (Hc) were evaluated on the basis of magnetization curves of the powdery/granular materials that had been measured with use of a vibrating sample magnetometer (VSM-C7-10A; TOEI INDUSTRY CO., LTD.).

### 4. Electron micrograph

After the powdery/granular material of Example 46 had been embedded and fixed in a resin, a thin film sample that can be observed with use of a transmission electron microscope was prepared with use of a focused ion beam processing device (Ethos NX5000; manufactured by Hitachi High-Tech Corporation). With use of a transmission electron microscope (H-9500; manufactured by Hitachi High-Tech Corporation), an electron micrograph of a cross-section of the thin film sample was captured under conditions of an acceleration voltage of 200 kV and a magnification of 500,000 times. Fig. 1 shows the captured picture.

### [Manufacture of magnetic material]

The iron-based magnetic powdery/granular materials of Examples and Comparative Examples were each mixed with an epoxy resin to prepare granulated powder, followed by molding the granulated powder by powder compacting (molding pressure: 5 MPa) into a ring shape, so that a compacted powder magnetic core (outer diameter: 15mm, inner diameter: 9mm, and thickness: 3mm) was produced as a magnetic material.

### [Evaluation of magnetic material]

The magnetic materials manufactured as described above were evaluated as follows.

### 5. Evaluation of filling factor

The filling factors were calculated from weights and external dimensions of the cores.

### 6. Magnetic properties of cores

### 6-1. Measurement of magnetic permeabilities

A toroidal core obtained by bifilar winding of a copper wire having a diameter of 0.3 mm on each of the compacted powder magnetic cores that had been evaluated as to the filling factors was prepared, and the toroidal core was used as an evaluation sample. With respect to the toroidal core, a magnetic permeability thereof was measured with use of a BH analyzer (SY8258; manufactured by Iwatsu Test Instruments Corporation), at a measurement frequency of 1 MHz, and at a maximum magnetic flux density of 25 mT.

### 6-2. Measurement of core loss

A toroidal core obtained by bifilar winding of a copper wire having a diameter of 0.3 mm on each of the compacted powder magnetic cores that had been evaluated as to the filling factors was prepared, and the toroidal core was used as an evaluation sample. With respect to the toroidal core, a core loss (TOTAL) thereof was measured with use of a BH analyzer (SY8258; manufactured by Iwatsu Test Instruments Corporation), at a measurement frequency of 1 MHz, and at a maximum magnetic flux density of 25 mT. Then, the core loss thus obtained was classified into a hysteresis loss (Ph) and an eddy current loss (Pe) with use of the Steinmetz's equation.

### [Result of evaluation]

Tables 1 to 4 show results of the evaluations of the iron-based magnetic powdery/granular materials and the magnetic materials. Tables 1 to 4 also show results of graded evaluations based on the evaluations.

In Tables 1 to 4, the numbers such as "1", "2", and the like of the graded evaluation "downsizing contribution" represent the following.
4: magnetic permeability µ > 25
3: 20 < magnetic permeability µ ≤ 25
2: 15 < magnetic permeability µ ≤ 20
1: magnetic permeability µ ≤ 15

In the magnetic material, a higher magnetic permeability µ enables, for example, the number of winding of the coil to be reduced, thereby making it possible to reduce the height of the magnetic material. The magnetic permeability µ tends to be improved when the coercivity Hc is lower or when the filling factor is lower due to a low hardness of the powdery/granular material.

In table 1, the numbers such as "1", "2", and the like in the graded evaluation "high-frequency driving contribution" represent the following.
5: 0 kw/m³ < eddy current loss Pe < 200 kw/m³
4: 200 kw/m³ ≤ eddy current loss Pe < 300 kw/m³
3: 300 kw/m³ ≤ eddy current loss Pe < 350 kw/m³
2: 350 kw/m³ ≤ eddy current loss Pe < 400 kw/m³
1: 400 kw/m³ ≤ eddy current loss Pe

Note that the eddy current loss Pe tends to decrease when the resistivity of the powdery/granular material is improved.

In Tables 1 to 4, the numbers such as "1", "2", and the like of the graded evaluation "magnetic property" represent the following.
5: The saturation magnetization Ms is increased and the coercivity Hc is reduced, compared to a Comparative Example consisting of the same amount of Ni, the same amount of Si, and the remaining portion of Fe (hereinafter, simply referred to as "Comparative Example")
4: Compared to Comparative Example, the saturation magnetization Ms is increased or the coercivity Hc is reduced, and
(saturation magnetization Ms of the sample - saturation magnetization Ms of Comparative Example) > -3emu/g and
(coercivity Hc of the sample/coercivity Hc of Comparative Example) ≤ 90%
3: Compared to Comparative Example, the saturation magnetization Ms is increased or the coercivity Hc is reduced, and the case falls outside the grade 4 above
2: Compared to Comparative Example, the saturation magnetization Ms and coercivity Hc are unchanged
1: Compared to Comparative Example, the saturation magnetization Ms is reduced, and the coercivity Hc is increased

### [Table 1]

**Table 1**

| | Composition of mixture (% by weight) | Particle size D50 (µm) | Hardness of powdery/granular material (HV) | Resistivity of powdery/gran ular material (µΩ · cm) | Magnetic physical property of powdery/granular material | |
|---|---|---|---|---|---|---|
| | | | | | Saturation magnetization (emu/g) | Coercivity (Oe) |
| Com. Example 1 | Fe | 3 | 210 | 8.87×10⁰ | 195 | 61 |
| Example 1 | Fe-1Al | 3 | 200 | 8.89×10² | 195 | 48 |
| Example 2 | Fe-3Al | 3 | 180 | 2.27×10³ | 194 | 37 |
| Example 3 | Fe-5Al | 3 | 165 | 7.93×10³ | 191 | 30 |
| Example 4 | Fe-0.5Ca | 3 | 225 | 3.37×10² | 193 | 45 |
| Example 5 | Fe-1Ca | 3 | 200 | 7.75×10² | 191 | 43 |
| Example 6 | Fe-0.5Al-0.5Ca | 3 | 200 | 8.02×10² | 191 | 45 |
| Example 7 | Fe-1Al-0.5Ca | 3 | 190 | 1.01×10³ | 195 | 41 |
| Example 8 | Fe-3Al-0.5Ca | 3 | 165 | 8.78×10² | 193 | 37 |
| Example 9 | Fe-5Al-0.5Ca | 3 | 150 | 1.02×10³ | 190 | 30 |
| Com. Example 2 | Fe-2Si | 3 | 320 | 1.02×10¹ | 192 | 40 |
| Example 10 | Fe-2Si-0.5Al | 3 | 300 | 2.12×10² | 192 | 38 |
| Example 11 | Fe-2Si-1Al | 3 | 200 | 2.88×10² | 192 | 35 |
| Example 12 | Fe-2Si-3Al | 3 | 240 | 8.84×10² | 191 | 30 |
| Example 13 | Fe-2Si-5Al | 3 | 230 | 1.02×10³ | 187 | 24 |
| Example 14 | Fe-2Si-0.5Ca | 3 | 315 | 3.77×10² | 192 | 36 |
| Example 15 | Fe-2Si-1Ca | 3 | 300 | 8.05×10² | 192 | 34 |
| Example 16 | Fe-2Si-0.5Al-0.5Ca | 3 | 300 | 2.76×10² | 192 | 36 |
| Example 17 | Fe-2Si-1Al-0.5Ca | 3 | 285 | 3.38×10² | 192 | 33 |
| Example 18 | Fe-2Si-3Al-0.5Ca | 3 | 250 | 1.23×10³ | 191 | 28 |
| Example 19 | Fe-2Si-5Al-0.5Ca | 3 | 240 | 1.76×10³ | 190 | 20 |

**Table 1 (Continued)**

| | Core magnetic physical property (in molding at pressure of 5t/cm²) | | | | | Evaluation | | |
|---|---|---|---|---|---|---|---|---|
| | Filling rate (% by volume) | Magnetic permeability | Core loss (@1MHz, 25mT) | | | Downsizing contribution | High-frequency driving contribution | Magnetic property |
| | | | TOTAL (kw/m³) | Hysteresis loss Ph (kw/m³) | Eddy current loss Pe (kw/m³) | | | |
| Com. Example 1 | 72.1 | 12.1 | 2281 | 1654 | 627 | 1 | 1 | - |
| Example 1 | 74.1 | 18.1 | 1456 | 1222 | 234 | 2 | 4 | 4 |
| Example 2 | 75.4 | 19.1 | 1382 | 1211 | 171 | 2 | 5 | 4 |
| Example 3 | 77.6 | 20.7 | 1372 | 1224 | 148 | 3 | 5 | 3 |
| Example 4 | 72.8 | 17.4 | 1489 | 1223 | 266 | 2 | 4 | 4 |
| Example 5 | 74.0 | 18.1 | 1428 | 1202 | 226 | 2 | 4 | 3 |
| Example 6 | 73.9 | 18.0 | 1381 | 1233 | 148 | 2 | 5 | 3 |
| Example 7 | 74.4 | 18.4 | 1321 | 1211 | 110 | 2 | 5 | 4 |
| Example 8 | 77.9 | 21.0 | 1211 | 1120 | 91 | 3 | 5 | 4 |
| Example 9 | 78.8 | 21.5 | 1120 | 1084 | 36 | 3 | 5 | 3 |
| Com. Example 2 | 70.9 | 18.4 | 1711 | 1322 | 389 | 2 | 4 | - |
| Example 10 | 71.5 | 19.1 | 1644 | 1309 | 335 | 2 | 3 | 3 |
| Example 11 | 71.8 | 19.4 | 1602 | 1300 | 302 | 2 | 3 | 4 |
| Example 12 | 73.2 | 20.9 | 1508 | 1250 | 258 | 3 | 4 | 4 |
| Example 13 | 73.3 | 20.8 | 1501 | 1260 | 241 | 3 | 4 | 3 |
| Example 14 | 71.1 | 18.9 | 1673 | 1323 | 350 | 2 | 4 | 4 |
| Example 15 | 72.0 | 19.2 | 1616 | 1309 | 307 | 2 | 3 | 4 |
| Example 16 | 72.1 | 19.2 | 1601 | 1305 | 296 | 2 | 4 | 4 |
| Example 17 | 73.3 | 20.8 | 1579 | 1303 | 276 | 3 | 4 | 4 |
| Example 18 | 73.8 | 21.5 | 1487 | 1250 | 237 | 3 | 4 | 4 |
| Example 19 | 73.8 | 21.5 | 1455 | 1244 | 211 | 3 | 4 | 4 |

### [Table 2]

**Table 2**

| | Composition of mixture (% by weight) | Particle size D50 (µm) | Hardness of powdery/granular material (HV) | Resistivity of powdery/granular material (µΩ · cm) | Magnetic physical property of powdery/granular material | |
|---|---|---|---|---|---|---|
| | | | | | Saturation magnetization (emu/g) | Coercivity (Oe) |
| Com. Example 3 | Fe-3.5Si | 3 | 375 | 1.14×10¹ | 186 | 35 |
| Com. Example 4 | Fe-3.5Si-4.5Cr | 3 | 368 | 1.29×10¹ | 184 | 42 |
| Com. Example 5 | Fe-3.5Si-1.5Cr | 3 | 360 | 1.28×10¹ | 188 | 38 |
| Example 20 | Fe-3.5Si-lAl | 3 | 345 | 3.51×10² | 189 | 32 |
| Example 21 | Fe-3.5Si-3Al | 3 | 280 | 4.48×10² | 182 | 28 |
| Example 22 | Fe-3.5Si-5Al | 3 | 255 | 1.24×10³ | 180 | 23 |
| Example 23 | Fe-3.5Si-0.5Ca | 3 | 360 | 4.12×10² | 189 | 33 |
| Example 24 | Fe-3.5Si-1Ca | 3 | 340 | 8.87×10² | 188 | 30 |
| Example 25 | Fe-3.5Si-0.5Al-0.5Ca | 3 | 340 | 4.42×10² | 188 | 32 |
| Example 26 | Fe-3.5Si-1Al-0.5Ca | 3 | 320 | 6.35×10² | 187 | 30 |
| Example 27 | Fe-3.5Si-3Al-0.5Ca | 3 | 260 | 8.77×10² | 185 | 27 |
| Example 28 | Fe-3.5Si-5Al-0.5Ca | 3 | 230 | 1.98×10³ | 180 | 22 |
| Com. Example 6 | Fe-6.5Si | 3 | 610 | 1.48×10¹ | 171 | 24 |
| Com. Example 7 | Fe-6.5Si-4.5Cr | 3 | 680 | 1.62×10¹ | 142 | 32 |
| Com. Example 8 | Fe-6.5Si-1.5Cr | 3 | 660 | 1.54×10¹ | 156 | 28 |
| Example 29 | Fe-6.5Si-1Al | 3 | 580 | 2.22×10² | 172 | 22 |
| Example 30 | Fe-6.5Si-3Al | 3 | 560 | 4.87×10² | 170 | 19 |
| Example 31 | Fe-6.5Si-5Al | 3 | 530 | 2.02×10³ | 168 | 16 |
| Example 32 | Fe-6.5Si-0.5Ca | 3 | 600 | 1.98×10² | 173 | 23 |
| Example 33 | Fe-6.5Si-1Ca | 3 | 590 | 2.10×10² | 170 | 20 |
| Example 34 | Fe-6.5Si-0.5Al-0.5Ca | 3 | 580 | 2.57×10² | 172 | 20 |
| Example 35 | Fe-6.5Si-1Al-0.5Ca | 3 | 575 | 2.98×10² | 171 | 19 |
| Example 36 | Fe-6.5Si-3Al-0.5Ca | 3 | 565 | 5.19×10² | 170 | 15 |
| Example 37 | Fe-6.5Si-5Al-0.5Ca | 3 | 520 | 2.89×10³ | 168 | 13 |

**Table 2 (Continued)**

| | Core magnetic physical property (in molding at pressure of 5t/cm²) | | | | | Evaluation | | |
|---|---|---|---|---|---|---|---|---|
| | Filling rate (% by volume) | Magnetic permeability | Core loss (@1MHz, 25mT) | | | Downsizing contribution | High-frequency driving contribution | Magnetic property |
| | | | TOTAL (kw/m³) | Hysteresis loss Ph (kw/m³) | Eddy current loss Pe (kw/m³) | | | |
| Com. Example 3 | 69.8 | 18.2 | 1635 | 1311 | 324 | 2 | 3 | - |
| Com. Example 4 | 68.1 | 17.6 | 1816 | 1345 | 471 | 2 | 1 | 1 |
| Com. Example 5 | 67.8 | 16.3 | 1793 | 1323 | 470 | 2 | 1 | 3 |
| Example 20 | 69.8 | 18.4 | 1600 | 1310 | 290 | 2 | 4 | 5 |
| Example 21 | 72.1 | 20.8 | 1512 | 1270 | 242 | 3 | 4 | 3 |
| Example 22 | 72.8 | 21.2 | 1506 | 1303 | 203 | 3 | 4 | 3 |
| Example 23 | 67.9 | 18.7 | 1633 | 1314 | 319 | 2 | 3 | 5 |
| Example 24 | 68.8 | 19.3 | 1628 | 1328 | 300 | 2 | 3 | 5 |
| Example 25 | 69.1 | 19.7 | 1598 | 1334 | 264 | 2 | 4 | 5 |
| Example 26 | 70.9 | 20.6 | 1568 | 1344 | 224 | 3 | 4 | 5 |
| Example 27 | 74.1 | 22.8 | 1477 | 1300 | 177 | 3 | 5 | 4 |
| Example 28 | 74.4 | 23.1 | 1402 | 1279 | 123 | 3 | 5 | 3 |
| Com. Example 6 | 63.2 | 14.2 | 1333 | 945 | 388 | 1 | 4 | - |
| Com. Example 7 | 61.1 | 13.3 | 1425 | 1022 | 403 | 1 | 1 | 1 |
| Com. Example 8 | 62.4 | 13.8 | 1389 | 988 | 401 | 1 | 1 | 1 |
| Example 29 | 65.1 | 15.3 | 1301 | 945 | 356 | 2 | 4 | 5 |
| Example 30 | 65.7 | 15.6 | 1219 | 956 | 263 | 2 | 4 | 4 |
| Example 31 | 66.9 | 15.9 | 1168 | 943 | 225 | 2 | 4 | 3 |
| Example 32 | 64.3 | 16.2 | 1345 | 969 | 376 | 2 | 4 | 5 |
| Example 33 | 64.6 | 16.5 | 1340 | 988 | 352 | 2 | 4 | 4 |
| Example 34 | 65.2 | 16.9 | 1300 | 980 | 320 | 2 | 3 | 5 |
| Example 35 | 65.2 | 16.8 | 1295 | 976 | 319 | 2 | 3 | 4 |
| Example 36 | 65.9 | 16.3 | 1206 | 955 | 251 | 2 | 4 | 4 |
| Example 37 | 66.5 | 16.1 | 1119 | 967 | 152 | 2 | 5 | 3 |

### [Table 3]

**Table 3**

| | Composition of mixture (% by weight) | Particle size D50 (µm) | Hardness of powdery/granular material (HV) | Resistivity of powdery/granular material (µΩ · cm) | Magnetic physical property of powdery/granular material | |
|---|---|---|---|---|---|---|
| | | | | | Saturation magnetization (emu/g) | Coercivity (Oe) |
| Com. Example 9 | Fe-10Ni | 3 | 240 | 1.14×10¹ | 180 | 46 |
| Example 38 | Fe-10Ni-1Al | 3 | 230 | 1.99×10³ | 195 | 46 |
| Example 39 | Fe-10Ni-3Al | 3 | 210 | 2.03×10³ | 194 | 44 |
| Example 40 | Fe-10Ni-5Al | 3 | 200 | 4.04×10³ | 191 | 40 |
| Example 41 | Fe-10Ni-0.5Ca | 3 | 240 | 1.30×10² | 195 | 46 |
| Example 42 | Fe-10Ni-1Ca | 3 | 230 | 4.49×10² | 195 | 44 |
| Example 43 | Fe-10Ni-0.5Al-0.5Ca | 3 | 230 | 1.85×10² | 195 | 45 |
| Example 44 | Fe-10Ni-1Al-0.5Ca | 3 | 220 | 2.22×10³ | 194 | 44 |
| Example 45 | Fe-10Ni-3Al-0.5Ca | 3 | 200 | 3.87×10³ | 194 | 43 |
| Example 46 | Fe-10Ni-5Al-0.5Ca | 3 | 190 | 5.54×10³ | 190 | 39 |
| Com. Example 10 | Fe-30Ni | 3 | 220 | 1.22×10¹ | 148 | 41 |
| Example 47 | Fe-30Ni-1Al | 3 | 200 | 2.00×10² | 166 | 40 |
| Example 48 | Fe-30Ni-3Al | 3 | 180 | 2.98×10² | 163 | 38 |
| Example 49 | Fe-30Ni-5Al | 3 | 170 | 3.61×10² | 160 | 35 |
| Example 50 | Fe-30Ni-0.5Ca | 3 | 220 | 1.57×10² | 167 | 40 |
| Example 51 | Fe-30Ni-1Ca | 3 | 215 | 1.88×10² | 167 | 38 |
| Example 52 | Fe-30Ni-0.5Al-0.5Ca | 3 | 210 | 1.77×10² | 167 | 38 |
| Example 53 | Fe-30Ni-1Al-0.5Ca | 3 | 200 | 2.12×10² | 166 | 38 |
| Example 54 | Fe-30Ni-3Al-0.5Ca | 3 | 185 | 3.87×10² | 161 | 37 |
| Example 55 | Fe-30Ni-5Al-0.5Ca | 3 | 180 | 5.52×10² | 158 | 34 |

**Table 3 (Continued)**

| | Core magnetic physical property (in molding at pressure of 5t/cm²) | | | | | Evaluation | | |
|---|---|---|---|---|---|---|---|---|
| | Filling rate (% by volume) | Magnetic permeability | Core loss (@1MHz, 25mT) | | | Downsizing contribution | High-frequency driving contribution | Magnetic property |
| | | | TOTAL (kw/m³) | Hysteresis loss Ph (kw/m³) | Eddy current loss Pe (kw/m³) | | | |
| Com. Example 9 | 71.2 | 19.9 | 1256 | 856 | 400 | 2 | 1 | - |
| Example 38 | 72.0 | 20.9 | 1187 | 933 | 254 | 3 | 4 | 3 |
| Example 39 | 73.0 | 21.2 | 1056 | 903 | 153 | 3 | 5 | 5 |
| Example 40 | 75.4 | 23.1 | 980 | 896 | 84 | 3 | 5 | 5 |
| Example 41 | 71.1 | 23.3 | 1234 | 945 | 289 | 3 | 4 | 3 |
| Example 42 | 71.8 | 23.8 | 1188 | 934 | 254 | 3 | 4 | 5 |
| Example 43 | 71.6 | 23.5 | 1172 | 924 | 248 | 3 | 4 | 5 |
| Example 44 | 72.1 | 24.1 | 1129 | 903 | 226 | 3 | 4 | 5 |
| Example 45 | 73.8 | 24.4 | 998 | 899 | 99 | 3 | 5 | 5 |
| Example 46 | 74.3 | 24.7 | 932 | 890 | 42 | 3 | 5 | 5 |
| Com. Example 10 | 72.2 | 20.3 | 1115 | 712 | 403 | 3 | 1 | - |
| Example 47 | 73.3 | 25.6 | 1087 | 711 | 376 | 4 | 4 | 5 |
| Example 48 | 75.7 | 27.7 | 989 | 722 | 267 | 4 | 4 | 5 |
| Example 49 | 77.0 | 28.9 | 954 | 756 | 198 | 4 | 5 | 5 |
| Example 50 | 72.3 | 24.1 | 1109 | 733 | 376 | 3 | 4 | 5 |
| Example 51 | 72.9 | 24.3 | 1093 | 789 | 304 | 3 | 3 | 5 |
| Example 52 | 73.2 | 24.7 | 1087 | 787 | 300 | 3 | 3 | 5 |
| Example 53 | 74.9 | 25.9 | 1056 | 799 | 257 | 4 | 4 | 5 |
| Example 54 | 74.1 | 25.3 | 988 | 774 | 214 | 4 | 4 | 5 |
| Example 55 | 74.9 | 26.0 | 954 | 768 | 186 | 4 | 5 | 5 |

### [Table 4]

**Table 4**

| | Composition of mixture (% by weight) | Particle size D50 (µm) | Hardness of powdery/gra nular material (HV) | Resistivity of powdery/granu lar material (µΩ · cm) | Magnetic physical property of powdery/granular material | |
|---|---|---|---|---|---|---|
| | | | | | Saturation magnetization (emu/g) | Coercivity (Oe) |
| Com. Example 11 | Fe-50Ni | 3 | 200 | 1.66×10¹ | 124 | 26 |
| Example 56 | Fe-50Ni-1Al | 3 | 190 | 9.85×10¹ | 129 | 26 |
| Example 57 | Fe-50Ni-3Al | 3 | 180 | 5.83×10² | 127 | 26 |
| Example 58 | Fe-50Ni-5Al | 3 | 160 | 4.22×10³ | 123 | 24 |
| Example 59 | Fe-50Ni-0.5Ca | 3 | 200 | 8.87×10¹ | 129 | 26 |
| Example 60 | Fe-50Ni-1Ca | 3 | 190 | 1.09×10² | 129 | 26 |
| Example 61 | Fe-50Ni-0.5Al-0.5Ca | 3 | 200 | 1.05×10² | 129 | 25 |
| Example 62 | Fe-50Ni-1Al-0.5Ca | 3 | 185 | 1.19×10² | 129 | 23 |
| Example 63 | Fe-50Ni-3Al-0.5Ca | 3 | 170 | 7.16×10² | 128 | 23 |
| Example 64 | Fe-50Ni-5Al-0.5Ca | 3 | 155 | 9.26×10² | 124 | 22 |
| Com. Example 12 | Fe-80Ni | 3 | 168 | 3.85×10¹ | 108 | 18 |
| Example 65 | Fe-80Ni-1Al | 3 | 160 | 9.89×10¹ | 108 | 18 |
| Example 66 | Fe-80Ni-3Al | 3 | 140 | 2.27×10² | 106 | 17 |
| Example 67 | Fe-80Ni-5Al | 3 | 135 | 6.54×10² | 105 | 16 |
| Example 68 | Fe-80Ni-0.5Ca | 3 | 165 | 6.78×10² | 108 | 18 |
| Example 69 | Fe-80Ni-1Ca | 3 | 160 | 7.89×10² | 108 | 18 |
| Example 70 | Fe-80Ni-0.5Al-0.5Ca | 3 | 160 | 8.90×10¹ | 108 | 18 |
| Example 71 | Fe-80Ni-1Al-0.5Ca | 3 | 155 | 1.24×10² | 107 | 17 |
| Example 72 | Fe-80Ni-3Al-0.5Ca | 3 | 135 | 2.88×10² | 106 | 16 |
| Example 73 | Fe-80Ni-5Al-0.5Ca | 3 | 130 | 8.68×10² | 105 | 15 |

**Table 4 (Continued)**

| | Core magnetic physical property (in molding at pressure of 5t/cm²) | | | | | Evaluation | | |
|---|---|---|---|---|---|---|---|---|
| | Filling rate (% by volume) | Magnetic permeability | Core loss (@1MHz, 25mT) | | | Downsizing contribution | High-frequency driving contribution | Magnetic property |
| | | | TOTAL (kw/m³) | Hysteresis loss Ph (kw/m³) | Eddy current loss Pe (kw/m³) | | | |
| Com. Example 11 | 74.7 | 23.3 | 1069 | 613 | 456 | 3 | 1 | - |
| Example 56 | 74.8 | 28.3 | 1060 | 655 | 405 | 4 | 1 | 3 |
| Example 57 | 75.1 | 28.5 | 1000 | 705 | 295 | 4 | 4 | 3 |
| Example 58 | 76.0 | 29.1 | 955 | 715 | 240 | 4 | 4 | 3 |
| Example 59 | 75.1 | 28.2 | 1065 | 687 | 378 | 4 | 4 | 3 |
| Example 60 | 75.3 | 28.5 | 1058 | 694 | 364 | 4 | 4 | 3 |
| Example 61 | 75.1 | 28.3 | 1044 | 693 | 351 | 4 | 4 | 5 |
| Example 62 | 74.8 | 28.3 | 1049 | 704 | 345 | 4 | 3 | 5 |
| Example 63 | 75.5 | 28.5 | 999 | 777 | 222 | 4 | 4 | 5 |
| Example 64 | 76.4 | 29.3 | 956 | 788 | 168 | 4 | 5 | 4 |
| Com. Example 12 | 76.5 | 26.5 | 921 | 533 | 388 | 4 | 4 | - |
| Example 65 | 75.8 | 31.0 | 888 | 546 | 342 | 4 | 3 | 4 |
| Example 66 | 76.5 | 31.3 | 845 | 555 | 290 | 4 | 4 | 3 |
| Example 67 | 76.8 | 32.2 | 838 | 589 | 249 | 4 | 4 | 3 |
| Example 68 | 75.6 | 30.0 | 890 | 550 | 340 | 4 | 3 | 4 |
| Example 69 | 75.8 | 30.3 | 884 | 577 | 307 | 4 | 3 | 4 |
| Example 70 | 75.6 | 30.8 | 877 | 580 | 297 | 4 | 4 | 4 |
| Example 71 | 75.9 | 31.7 | 867 | 578 | 289 | 4 | 4 | 3 |
| Example 72 | 77.7 | 32.4 | 844 | 557 | 287 | 4 | 4 | 4 |
| Example 73 | 77.9 | 32.6 | 831 | 569 | 262 | 4 | 4 | 3 |

As shown in Tables 1 to 4, each of the iron-based magnetic powdery/granular materials in accordance with Examples, compared to the iron-based magnetic powdery/granular material in accordance with Comparative Example, in particular, the iron-based magnetic powdery/granular material in accordance with Comparative Example that has the same percentage by weight of Si or Ni, has a high resistivity, a high saturation magnetization and a low coercivity, and has a property of making it possible to, while enhancing at least one of feasibility of reduction in size of a magnetic material, feasibility of application of the magnetic material to a high-frequency current, and magnetic properties of the magnetic material, maintain or enhance the other properties. Similarly, the compacted powder magnetic cores in which the iron-based magnetic powdery/granular materials in accordance with Examples are used each have a high magnetic permeability and a low core loss, resulting in enhancement in at least one of feasibility of reduction in size, feasibility of application to a high-frequency current, and magnetic properties, compared to a compacted powder magnetic core in which the iron-based magnetic powdery/granular material in accordance with Comparative Example is used.

Furthermore, as illustrated in Fig. 1, in the vicinity of the surface of the iron-based magnetic powdery/granular material in accordance with Example 46, it was observed that an oxide film (12) had been formed on the surface of the iron-based magnetic alloy (11). The oxide film is thought to be made of an oxide of the element M. Further, the iron-based magnetic powdery/granular material in accordance with Example 46 exhibited a high resistivity. Thus, it was demonstrated that the oxide film contributes to improvement in a resistivity.

## Claims

1. An iron-based magnetic powdery/granular material containing an iron-based magnetic alloy composed of elements Fe, L, and M,
- the element L being at least one element selected from the group consisting of Ni and Si,
- the element M being at least one element selected from the group consisting of metal elements each having an ionization tendency higher than that of the element Fe,
- in the iron-based magnetic powdery/granular material, the elements Fe, L, and M being contained in a total amount of not less than 97.0% by weight and not more than 100.0% by weight, the element L being contained in an amount of not less than 0.0% by weight and not more than 80.0% by weight, and the element M being contained in an amount of not less than 0.3% by weight and not more than 10.0% by weight, relative to 100.0% by weight of the iron-based magnetic powdery/granular material, and
- the iron-based magnetic powdery/granular material having a resistivity of not less than 80 µΩ·cm.

2. The iron-based magnetic powdery/granular material according to claim 1, wherein the element L is Ni.

3. The iron-based magnetic powdery/granular material according to claim 1, wherein:
- the element L is Si; and
- the iron-based magnetic powdery/granular material has a resistivity of not less than 80 µΩ·cm.

4. The iron-based magnetic powdery/granular material according to any one of claims 1 to 3, wherein the iron-based magnetic powdery/granular material has a particle size (D50) of not less than 0.3 µm and not more than 30.0 µm.

5. The iron-based magnetic powdery/granular material according to any one of claims 1 to 4, wherein the iron-based magnetic powdery/granular material has a hardness of not more than 600 HV.

6. The iron-based magnetic powdery/granular material according to any one of claims 1 to 5, wherein:
- the iron-based magnetic powdery/granular material has a saturation magnetization of not less than 100 emu/g; and
- the iron-based magnetic powdery/granular material has a coercivity of not more than 50 Oe.

7. A magnetic material comprising the iron-based magnetic powdery/granular material according to any one of claims 1 to 6.

8. A method for manufacturing the iron-based magnetic powdery/granular material according to any one of claims 1 to 6, the method comprising:
- a step of subjecting a mixture composed of elements Fe, L, and M to a water atomization process to obtain a powdery/granular material made of an iron-based magnetic alloy, wherein in the mixture, the elements Fe, L, and M are contained in a total amount of not less than 97.0% by weight and not more than 100.0% by weight, the element L is contained in an amount of not less than 0.0% by weight and not more than 80.0% by weight, and the element M is contained in an amount of not less than 0.3% by weight and not more than 10.0% by weight, relative to 100.0% by weight of the mixture; and
- a step of drying, under reduced pressure and at a temperature of not higher than 110°C, the powdery/granular material thus obtained.
